Europäisches Patentamt

European Patent Office

Office européen des brevets

(11) Veröffentlichungsnummer: **0 407 635 A1**

# (12) EUROPÄISCHE PATENTANMELDUNG

(21) Anmeldenummer: **89112678.1**

(22) Anmeldetag: **11.07.89**

(51) Int. Cl.⁵: **H03K 17/08**

(43) Veröffentlichungstag der Anmeldung:
**16.01.91 Patentblatt 91/03**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Gantioler, Josef Matthias, Dipl.-Ing.**
**Bernheimerstrasse 6**
**D-8000 München 81(DE)**
Erfinder: **Tihanyi, Jenö, Dr.**
**Windeckstrasse 1d**
**D-8000 München 70(DE)**

(54) Schaltungsanordnung zum Ansteuern eines Thyristors durch einen Fototransistor.

(57) Als Schutz gegen ein ungewolltes Einschalten des Thyristors (1) durch eine du/dt-Belastung ist ein MOSFET (14) vorgesehen, der den bei einer du/dt-Belastung auftretenden Basisstrom des Fototransistors (10) ableitet. Zwischen Gate- und Sourceanschluß sind parallel ein erster Kondensator (15) und eine Stromquelle (17) angeschlossen. Der Kondensator (15) ist über eine Diode mit einem zweiten Kondensator (19) verbunden, an dem eine der Versorgungsspannung folgende Spannung liegt. Durch eine du/dt-Belastung wird der erste Kondensator (15) aufgeladen. Die Stromquelle (17) entlädt diesen Kondensator (15) derart, daß der MOSFET (14) nach einer du/dt-Belastung für eine definierte Zeit, z. B. eine Halbwelle leitend und der du/dt-Schutz gewährleistet bleibt.

# SCHALTUNGSANORDNUNG ZUM ANSTEUERN EINES THYRISTORS DURCH EINEN FOTOTRANSISTOR

Die Erfindung bezieht sich auf eine Schaltungsanordnung zum Ansteuern eines Thyristors durch einen Fototransistor, mit einem MOSFET, dessen Drain-Sourcestrecke einerseits mit dem Basisanschluß des Fototransistors und andererseits mit einer Ausgangsklemme verbunden ist, und mit einer Reihenschaltung aus einem ersten Kondensator und einer ersten Stromquelle.

Eine solche Schaltungsanordnung ist z. B. in der EP-144 978 B1 beschrieben worden. Zweck dieser Schaltungsanordnung ist es, ein ungewolltes Einschalten aufgrund einer du/dt-Belastung zu verhindern. In der bekannten Schaltungsanordnung wird dies dadurch erreicht, daß der bei einer du/dt-Belastung aufgrund der Basis-Kollektorkapazität des Fototransistors fließende Basisstrom durch den MOSFET z. B. nach Masse abgeleitet wird. Der Gateanschluß des MOSFET ist über einen Kondensator mit einer Klemme verbunden, an der eine der Versorgungsspannung folgende Spannung anliegt. Tritt auf der Versorgungsspannungsseite ein steiler Spannungsanstieg du/dt auf, so fließt ein Strom durch den Kondensator und steuert den MOSFET leitend. Dieser leitet damit den aufgrund der du/dt-Belastung fließenden kapazitiven Sperrstrom des Fototransistors 1 ab. Dieser schaltet damit nicht ein und ein ungewolltes Einschalten des Thyristors unterbleibt.

Um eine Belastung des Fototransistors in Sperrrichtung zu vermeiden, ist zwischen dem Kollektoranschluß des Fototransistors und dem Anodenanschluß des Thyristors eine Diode angeschlossen. Treten nun während einer Halbwelle der Versorgungsspannung mehrere du/dt-Belastungen hintereinander auf, so kann es vorkommen, daß der Kondensator voll aufgeladen wird. Da er sich über die Diode nicht entladen kann, kann kein Kondensatorstrom fließen und der MOSFET kann innerhalb der genannten Halbwelle wieder gesperrt werden. Tritt nun eine erneute du/dt-Belastung auf, so kann der MOSFET wegen des geladenen Kondensators nicht mehr leitend gesteuert werden und der aufgrund dieser du/dt-Belastung fließende kapazitive Kollektor-Basisstrom des Fototransistors steuert den Fototransistor leitend. Der Thyristor kann dann unbeabsichtigt eingeschaltet werden.

Ziel der Erfindung ist es, eine Schaltungsanordnung der genannten Art derart weiterzubilden, daß ein Einschalten des Leistungs-Halbleiterbauelements auch dann sicher verhindert wird, wenn während einer Halbwelle der Versorgungsspannung mehrere du/dt-Belastungen hintereinander auftreten.

Dieses Ziel wird erreicht durch einen zweiten Kondensator, der zwischen Gateanschluß und Sourceanschluß des MOSFET angeschlossen ist, durch eine zweite Stromquelle, die dem zweiten Kondensator parallel geschaltet ist und durch eine Diode, die zwischen dem Gateanschluß des MOSFET und dem Verbindungspunkt zwischen erster Stromquelle und erstem Kondensator angeschlossen ist derart, daß Strom vom ersten Kondensator zum zweiten Kondensator fließen kann.

Weiterbildungen der Erfindung sind Gegenstand der Unteransprüche.

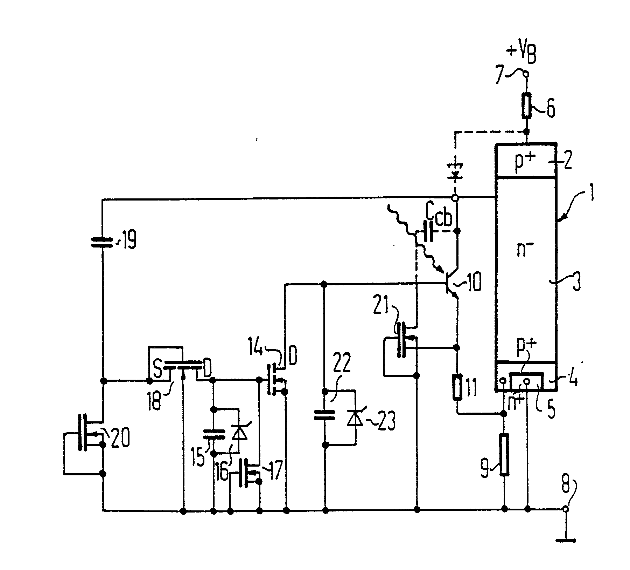

Die Erfindung wird anhand eines Ausführungsbeispiels in Verbindung mit der Figur beschrieben.

In der FIG ist der Thyristor mit 1 bezeichnet. Der Thyristor 1 hat eine Anodenzone 2, eine Mittelzone 3, eine Steuerzone 4 und eine Emitterzone 5. Der Leitfähigkeitstyp ist ausgehend von der Emitterzone zur Anodenzone npnp. Der Thyristor 1 ist anodenseitig mit einer Last 6 verbunden, die ihrerseits mit einer Anschlußklemme 7 verbunden ist. An dieser liegt eine Versorgungsspannung $V_B$. Die Emitterzone 5 liegt über eine Anschlußklemme 8 z. B. auf Massepotential.

Die Mittelzone 3 des Thyristors 1 ist mit dem Kollektoranschluß eines Fototransistors 10 verbunden, dessen Emitteranschluß über einen Widerstand 11 mit der Steuerzone 4 verbunden ist. Die Steuerzone 4 ist ihrerseits über einen Nebenschlußwiderstand 9 mit der Emitterzone 5 verbunden.

Fällt Licht auf den Fototransistor 10, so fließt sein Fotostrom über den Widerstand 11 in die Steuerzone 4 des Thyristors und zündet diesen, sofern die Thyristorspannung eine ausreichende Höhe aufweist. Wenn an den Anschlußklemmen 7, 8 eine du/dt-Belastung auftritt, wird im Inneren des Thyristors ein Verschiebungsstrom erzeugt. Ein Zünden wird durch den Nebenschlußwiderstand 9, der im allgemeinen fest im Thyristor eingebaut ist, verhindert. Zusätzlich fließt jedoch ein kapazitiver Strom durch die Kollektor-Basiskapazität $C_{cb}$ des Fototransistors 10 und steuert den Fototransistor 10 auch im unbeleuchteten Zustand leitend. Dieser kapazitive Strom wird im Fototransistor 10 verstärkt und fließt als Zündstrom in den Thyristor und zündet diesen trotz des Nebenschlußwiderstands 9.

Mit dem Basisanschluß des Fototransistors 10 ist daher der Drainanschluß eines MOSFET 14 verbunden, dessen Sourceanschluß mit der Anschlußklemme 8 verbunden ist. Der Gateanschluß des MOSFET 14 ist über eine Diode 18, z. B. eine MOS-Diode mit einem Anschluß eines Kondensators 19 verbunden, dessen anderer Anschluß mit dem Kollektor des Fototransistors 10 und mit der Mittelzone 3 des Thyristors 1 verbunden ist. Zwischen dem Gateanschluß und dem Sourceanschluß des MOSFET 14 ist ein Kondensator 15 angeschlossen, dem eine Stromquelle 17 parallel geschaltet ist. Der Stromquelle und dem Kondensator ist noch eine Zenerdiode 16 parallelgeschaltet, die die Gate-Sourcespannung von 14 begrenzt. Zwischen der Anschlußklemme 8 und dem Kondensator 19 liegt eine weitere Stromquelle 20.

Zur Erläuterung der Wirkungsweise des du/dt-Schutzes wird davon ausgegangen, daß der Thyristor 1 gesperrt ist und daß an den Anschlußklemmen 7, 8 eine Reihe von Spannungssprüngen mit hohem du/dt auftreten. Der erste dieser Spannungssprünge lädt den Kondensator 19 auf. Es fließt daher ein Strom in den Kondensator und in die Gate-Sourcekapazität des MOSFET 14. Der Kondensator 15 und die Gate-Sourcekapazität sind derart dimensioniert, daß der MOSFET 14 beim Auftreten einer ersten kritischen du/dt-Belastung leitend gesteuert wird. Dann wird der kapazitive Kollektor-Basisstrom des Fototransistors zur Anschlußklemme 8 abgeleitet.

Der Kondensator 19 wird zwar von der Stromquelle 20 entladen. Sie läßt aber nur einen geringen Strom zu, der gerade so groß ist, daß der Kondensator 19 zu Beginn der nächsten gleichgerichteten Halbwelle entladen ist. Treten nun während der erwähnten ersten Halbwelle mehrere du/dt-Belastungen hintereinander auf, so bleibt der Kondensator 19 vollständig aufgeladen und es fließt kein Kondensatorstrom mehr. Ohne den Kondensator 15 würde der MOSFET 14 nach Abklingen der ersten du/dt-Belastung daher wieder gesperrt und könnte durch weitere du/dt-Belastungen während der gleichen Halbwelle nicht mehr eingeschaltet werden. Damit könnten diese weiteren du/dt-Belastungen den Thyristor zünden. Durch Einfügen des Kondensators 15 wird der MOSFET 14 beginnend mit der ersten du/dt-Belastung während einer Halbwelle sicher leitend gehalten.

Die Stromquelle 17 besteht üblicherweise aus einem Depletion-FET, bei dem Gateanschluß und Sourceanschluß miteinander verbunden sind. Entsprechend ist die Stromquelle 20 aufgebaut. Die Stromquelle 17 ist derart dimensioniert, daß der durch die erste du/dt-Belastung aufgeladene Kondensator 15 sicher vor Beginn der nächsten gleich gerichteten Halbwelle entladen ist. Dann kann die erste du/dt-Belastung auf der nächsten gleich gerichteten Halbwelle den Kondensator 15 wieder aufladen und den MOSFET 14 leitend steuern und bis zum Ende dieser Halbwelle leitend halten.

Der Kollektor des Fototransistors 10 ist in einer integrierten Schaltung an die Mittelzone 3 angeschlossen. Beim diskreten Aufbau wird er an die Anodenzone 2 angeschlossen, eventuell unter Einschaltung einer Diode (gestrichelt gezeichnet). Diese Diode hat den Zweck, eine Sperrbelastung des Emitter-Basis pn-Übergangs des Fototransistors 10 zu verhindern. Beim Anschluß des Kollektors an die Mittelzone 3 wird diese Wirkung durch den pn-Übergang zwischen den Zonen 2 und 3 erreicht.

Zwischen dem Basisanschluß und dem Emitteranschluß des Fototransistors 10 kann die Drain-Sourcestrecke eines Depletion-FET 21 eingeschaltet sein, dessen Gateanschluß und dessen Substratanschluß miteinander verbunden sind und z. B. an Massepotential liegen. Damit wird in Verbindung mit dem Widerstand 11 erreicht, daß zwischen Basisanschluß und Emitteranschluß des Fototransistors 10 im unbeleuchteten Zustand ein niedriger Widerstand und mit stärker werdenden Lichteinfall immer höherer Widerstand liegt. Dies verhindert ein Einschalten des Fototransistors im unbeleuchteten Zustand aufgrund hoher Temperaturen.

Zwischen dem Basisanschluß des Fototransistors 10 und der Anschlußklemme 8 (Masse) kann ein Kondensator 22 liegen, dem eine Zenerdiode 23 parallel geschaltet ist. Der Kondensator 22 dient dazu, die Basis-Emitterkapazität des Fototransistors 10 zu vergrößern. Damit wird auf jeden Fall sichergestellt, daß der MOSFET 14 einschaltet, bevor der Fototransistor 10 aufgrund einer du/dt-Belastung einschalten kann.

**Ansprüche**

1. Schaltungsanordnung zum Ansteuern eines Thyristors (1) durch einen Fototransistor (10), mit einem MOSFET (14), dessen Drain-Sourcestrecke einerseits mit dem Basisanschluß des Fototransistors und andererseits mit einer Ausgangsklemme (8) verbunden ist, und mit einer Reihenschaltung aus einem ersten Kondensator (19) und einer ersten Stromquelle (20)
**gekennzeichnet durch** einen zweiten Kondensator (15), der zwischen Gateanschluß und Sourceanschluß des MOSFET (14) angeschlossen ist, durch eine zweite Stromquelle (17), die dem zweiten Kondensator parallel geschaltet ist und durch eine Diode (18), die zwischen dem Gateanschluß des MOSFET und dem Verbindungspunkt zwischen erster Stromquelle und erstem Kondensator angeschlossen ist derart, daß Strom vom ersten Kondensator (19) zum zweiten Kondensator (15) fließen kann.

2. Schaltungsanordnung nach Anspruch 1,
**dadurch gekennzeichnet,** daß zwischen Gate- und Sourceanschluß des MOSFET eine Zenerdiode (16) angeschlossen ist.

3. Schaltungsanordnung nach Anspruch 1,
**dadurch gekennzeichnet,** daß die Diode (18) eine MOS-Diode ist.

4. Schaltungsanordnung nach Anspruch 1,
**dadurch gekennzeichnet,** daß die Stromquellen (17, 20) je aus einem Depletion-MOSFET bestehen, dessen Gateanschluß mit seinem Sourcean-

schluß verbunden ist.

Europäisches
Patentamt

**EUROPÄISCHER RECHERCHENBERICHT**

Nummer der Anmeldung

EP 89 11 2678

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | EP-A-0 144 978 (SIEMENS)<br>* Seite 3 - Seite 6, Zeile 9; Figur 1 *<br>----- | 1,2,4 | H 03 K 17/08 |

RECHERCHIERTE
SACHGEBIETE (Int. Cl.5)

H 03 K
H 01 L
H 02 M

Der vorliegende Recherchenbericht wurde für alle Patentansprüche erstellt

| Recherchenort | Abschlußdatum der Recherche | Prüfer |
|---|---|---|
| DEN HAAG | 09-03-1990 | CANTARELLI R.J.H. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument

EPO FORM 1503 03.82 (P0403)